# EUROPEAN PATENT SPECIFICATION

(11) **EP 2 444 527 B1**
(45) Date of publication and mention of the grant of the patent: **20.02.2019**
(21) Application number: 11185970.8
(22) Date of filing: 20.10.2011
(51) Int. Cl.: C25D 3/32, H05K 3/06

(54) **TIN PLATING SOLUTION**
ZINNBAD
SOLUTION DE PLACAGE D'ÉTAIN

(30) Priority: 22.10.2010 JP 2010237220
(43) Date of publication of application: 25.04.2012
(73) Proprietor: Rohm and Haas Electronic Materials LLC, Marlborough, MA 01752 (US)
(72) Inventor: Hayashi, Shinjiro, Niigata-shi Niigata 950-0925 (JP); Sakai, Makoto, Niigata-shi Niigata 950-0915 (JP)
(74) Representative: Houghton, Mark Phillip

(56) References cited:
- EP-A2- 1 342 816
- WO-A1-2004/013382
- US-A- 4 701 244
- US-A- 4 923 576

## Description

### Field of the Invention

The present invention relates to a tin plating solution, specifically, a tin plating solution used for a matte tin plating of a metal resist for a printed board.

### Background of the Invention

Tin plating or tin-lead alloy plating has been used for soldering or etching resists. However, according to the recent technical development, wiring pattern of printed board becomes more complex, so that the form of goods to be plated also becomes more complex. As a result, it is required to form uniform plating films on both fine parts and broad parts at same time. Furthermore, when the printed board to be plated has through-holes, the formation of a uniform plated film even within the through-holes is desired.

Since the conventional tin plating solution which can form a uniform plating film inside through-holes contains a strong suppressor, the precipitated particles becomes bigger, and burn deposits, dendritic precipitation or powder precipitation, readily occur in sections of high current density. To prevent such problems, the amount of metal ions has been increased and the temperature of the plating bath has been raised, the thicknesses of plating film on fine parts and broad parts becomes quite different, and so-called film thickness distribution on a plate becomes acceptable and the burn deposit in high current density does not occurr. Furthermore, lowering the current density reduces burn deposits, but it is not practical because the plating efficiency per time falls.

Although high throw baths, low metal concentration / high acid concentration, can deliver good thickness uniformity, the baths require operations under low current density because the limiting current density falls in high throw baths. WO-A-2004/013382 discloses a composition for tin plating baths, the composition comprising an ethylene oxide/propylene oxide copolymer and an amphoteric surfactant that is soluble in aqueous acids and comprises a quaternary ammonium group and a fatty acid group.

JP3336621 discloses a composition for tin plating bath comprising a metal ion, a conductive acid or a salt thereof, non-ionic surfactant and at least one phenanthroline compound, wherein the acidity of the bath is acid or weak acid. However, as discussed later, even if non-ionic surfactants are used as the surfactants, the thickness of plating film becomes thin in the section of low current density, so that the film thickness distribution of a plate becomes worse.

US4923576 discloses a tin-lead alloy plating solution comprising a heterocyclic-ring compound having at least two nitrogen atoms. However, as discussed later, some compounds with at least two nitrogen atoms described in the patent would still cause the problem of forming a non-uniform plating appearance on a printed board having through-holes.

### Summary of the Invention

The present invention was devised in light of aforementioned problems with conventional technology. The object of the present invention is to provide a tin plating solution having outstanding uniformity of through-hole plating, outstanding uniformity of film thickness distribution and no burn deposits even in plating for the recent printed boards having complexity of wiring patterns.

The inventors have researched tin plating solutions and perfected the current invention by discovering that a tin plating solution including the combination of some specific compounds known as components of plating solution itself achieves uniform film thickness distribution, without burn deposits and with outstanding plating uniformity within through-holes, i.e. throwing power.

Specifically, the present invention relates to a tin plating solution including a tin ion source, at least one non-ionic surfactant, imidazoline dicarboxylate and 1,10-phenanthroline. The non-ionic surfactants are alkyl alcohol ethylene oxide adducts containing 7 or more moles of ethylene oxide substituents in a molecule. In addition, the tin plating solution pursuant to the present invention could comprise antioxidants.

### Detailed Description of the Invention

The following abbreviations that are used throughout the specification have the following meaning unless another meaning is clear from the context. °C = degrees celcius, g = grams, mL = milliliters, L = liters, wt% = weight %, A/dm² and ASD = ampere per square decimeter, µm = micrometer.

The present invention, in its various aspects, is as set out in the accompanying claims.

The tin plating solution of the present invention includes a tin ion source, at least one type of non-ionic surfactant, imidazoline dicarboxylate and 1,10-phenanthroline.

Any tin ion source can be used as long as the tin ion source can form tin ions when the tin ion source is dissolved in a plating solution. Inorganic or organic tin salts may be used. Examples of tin ion sources include tin sulfate, tin borofluoride, tin halides, tin methanesulfonate, tin ethane sulfonate, tin propanesulfonate, tin 2-hydroxyethane-1-sulfonate, tin 2-hydroxypropane-1-sulfonate, tin 1-hydroxypropane-2-sulfonic acid. These may be used alone or in combinations of two or more.

The concentration of the tin ion source in the plating solution is preferably in the range of 5 to 35 g/L as metallic tin, more preferably 10 to 30 g/L, most preferably 15 to 25 g/L.

The non-ionic surfactant used is an alkyl alcohol ethylene oxide adduct containing 7 or more moles of ethylene oxide substituents in a molecule, preferably 7 to 20 moles.

The concentration of non-ionic surfactant in the plating solution preferably would be in the range of 1 to 4.5 g/L, more preferably 1.5 to 3 g/L, and most preferably 2 to 2.5 g/L.

The imidazoline dicarboxylate used in the present invention would be a compound having the following structure. The imidazoline dicarboxylate in the following structural formula is represented as a sodium salt, but the imidazoline dicarboxylate used in the present invention is not restricted to a sodium salt. Arbitrary salts may be used.

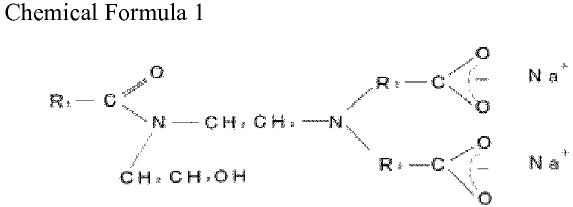

Wherein R₁ represents an alkyl group having 1 to 20 carbon atoms, R₂ and R₃ represent alkylene groups with direct bonds or 1 to 5 carbon atoms that may be identical or mutually different. The concentration of imidazoline dicarboxylate in the plating solution preferably would be in the range of 0.2 to 1.0 g/L, more preferably 0.3 to 0.7 g/L, most preferably 0.4 to 0.6 g/L.

Commercial 1,10-phenanthroline can be used. The concentration of 1,10-phenanthroline in the plating solution preferably would be 0.5 to 4 ppm based on weight, more preferably 1 to 3 ppm, and most preferably 1.5 to 2.5 ppm.

The tin plating solution of the present invention can also comprise antioxidants, pH regulators, foam inhibitors, and defoaming agents as needed.

Antioxidants commonly used in plating solutions can be used. Preferable antioxidants include catechol, hydroxybenzene sulfonate and ascorbic acid.

The tin plating solution of the present invention can be used as a plating solution for etching resist of printed boards. Etching resists of printed boards act as protective films against alkali etching solutions used in circuit formation. For example, the tin plating solution of the present invention is used to the printed board conducted drilling a hole, cleaning, etching the surface, electroconductive treatment by electro less copper plating, patterning with plating resist and electric copper plating, pattern plating, to protect circuit wiring from etching solution. That would be followed by peeling of the plating resist and etching using etching solution. Subsequently, the plating layer would be peeled off and appropriate processing would be carried out as required and the product would be mounted.

The present invention is explained in further detail below through examples, but the present invention is not restricted to these examples.

### Examples

### Evaluation Test

Hull cell tests and slit hull cell tests were carried out under the following conditions in order to evaluate the performance of plating solution prepared in each example and comparative example. In addition, the throwing power was measured in order to evaluate the plating uniformity on through-holes. The hull cell test is a test method for evaluating the plating appearance over a broad range of current densities as well as the film thickness distribution. The slit hull cell test is a test method for evaluating the precipitation properties at low current density.

### Conditions

Hull cell test
Current: 1 amp
Plating time: 5 minutes
Stirring speed: 2 m/minute
Bath temperature: 23°C
Slit hull cell test
Current: 0.1 amp
Plating time: 3 minutes
Stirring: None
Bath temperature: 23°C
Throwing power
Bath temperature: 23°C
Stirring speed: 1.2 m/minute
Plating cell: Haring cell
Amount of solution: 1.5 L
Plating thickness: 7 µm
Current density: 1.5 ASD

### Working Examples 1 to 3 and Comparative Examples 1 to 6

Tin plating solutions having the formulations shown in Table 1 below were prepared and used in hull cell tests and plating tests on test boards. The plating tests on test boards confirmed the precipitation states in high current density sections as well as in low current density sections through electroplating that was carried out using circuit boards that have both so-called solid sections and broad land sections, ground area, as well as independent sections, isolated areas.

**Table 1**

| Components | Working Examples | | | Comparative Examples | | | | | |
|---|---|---|---|---|---|---|---|---|---|
| | 1 | 2 | 3 | 1 | 2 | 3 | 4 | 5 | 6 |
| Tin sulfate (g/L, as metallic tin) | 20 | 15 | 10 | 20 | 15 | 10 | 20 | 15 | 10 |
| Sulfuric acid (mL/L) | 100 | 100 | 100 | 100 | 100 | 100 | 100 | 100 | 100 |
| Surfactant A (g/L) | 2.25 | 2.25 | 2.25 | 2.25 | 2.25 | 2.25 | 2.25 | 2.25 | 2.25 |
| Surfactant B (g/L) | 0.5 | 0.5 | 0.5 | - | - | - | 0.5 | 0.5 | 0.5 |
| 1,10-phenanthroline ppm | 2 | 2 | 2 | 2 | 2 | 2 | - | - | - |
| Hull cell test results | good | good | good | good | good | good | Burn deposit | Burn deposit | Burn deposit |
| Ground area plating precipition state | good | good | good | good | good | good | good | good | poor |
| Throwing power measurement results *1 | +++ | +++ | ++++ | + | ++ | +++ | +++ | + | +++ |

Surfactant A: Alkyl alcohol ethylene oxide, RO(CH₂CH₂O)xH, R=C₁₀H₂₁, X=8 Surfactant B: Imidazoline dicarboxylate having the following structure (Trade name: AMPHOTERGE™ K-2, product of Lonza Inc.)

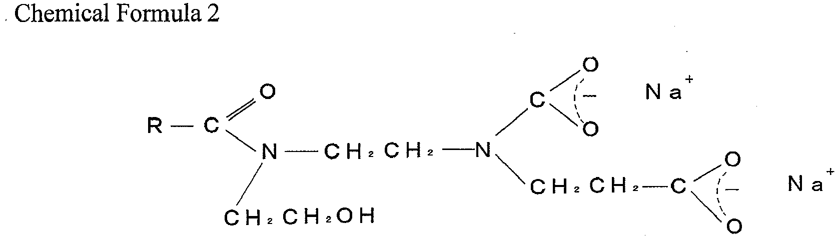

In the formula, R represents coco-alkyl.
*1: The throwing power measurement results are represented as follows, 150 or more ++++, 90 or more +++, 80 to 89: ++, under 80: +

Table 1 shows the results. The examples that do not comprise surfactant B (Comparative Examples 1 to 3) did not provide good results in measurements of the throwing power. Furthermore, examples that did not use 1,10-phenanthroline (comparative examples 4-6), burn deposit was observed in all hull cell tests. In Comparative Example 6, the plating precipitation state of the ground area was poor while the throwing power measurement results in comparative example 5 were poor. In contrast, in the examples using the tin plating solution pursuant to the present invention, Embodiments 1 to 3, the hull cell test ground area plating precipitation state as well as the throwing power measurement results were all good.

### Working Example 4 and Comparative Examples 7 to 10

Tin plating solutions having the formulation shown in Table 2 below were prepared, and both hull cell tests and plating on the test circuit board were carried out.

**Table 2**

| Components | Working Example | Comparative Examples | | | |
|---|---|---|---|---|---|
| | 4 | 7 | 8 | 9 | 10 |
| Tin sulfate (g/L, as metallic tin) | 20 | 20 | 20 | 20 | 20 |
| Sulfuric acid (mL/L) | 100 | 100 | 100 | 100 | 100 |
| Surfactant A (g/L) | 2.25 | 2.25 | 2.25 | 2.25 | 2.25 |
| Surfactant B (g/L) | 0.5 | 0.5 | 0.5 | 0.5 | 0.5 |
| 1,10-phenanthroline ppm | 2 | - | - | - | - |
| Bipyridine ppm | - | 1 | 2 | 5 | 10 |
| Hull cell test results | good | good | Burn deposit | Burn deposit | Burn deposit |
| Throwing power measurement results *1 | +++ | + | + | - | - |

| | | | | | |
|---|---|---|---|---|---|
| Surfactant A: Alkyl alcohol ethylene oxide, RO(CH₂CH₂O)xH, R=C₁₀H₂₁, X=8 Surfactant B: Imidazoline dicarboxylate (Trade name: AMPHOTERGE™ K-2, product of Lonza Inc.) Bipyridine structure: 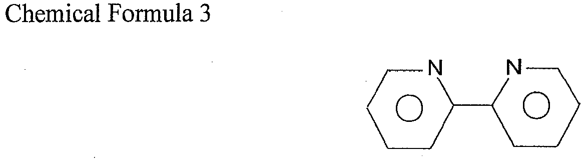 *1: The throwing power measurement results are represented as follows, 90 or more +++, 80 to 89: ++, under 80: + | | | | | |

Table 2 shows the results. The examples that used bipyridine instead of 1,10-phenanthroline, Comparative Examples 7 to 10, observed burn deposit in hull cell tests of 2 ppm or more of bipyridine, while the throwing power was under 80 at concentrations of less than 2 ppm.

### Working Example 5 and Comparative Examples 11 to 17

Tin plating solutions having the formulation shown in Table 3 below were prepared, and both hull cell tests and slit hull cell tests were carried out. The plating film thickness at sites of low current density was measured in hull cell tests and slit hull cell tests. The plating film thickness was measured using a fluorescent X-ray micro-coating thickness gauge at a total of nine points in hull cell panels at 1 cm separations to the right beginning at sections 1 cm from the left and 1 cm from the bottom. The film thickness at the ninth point is shown in Table 3 as #9 film thickness.

**Table 3**

| Components | Working Example | Comparative Examples | | | | | | |
|---|---|---|---|---|---|---|---|---|
| | 5 | 11 | 12 | 13 | 14 | 15 | 16 | 17 |
| Tin sulfate (g/L, as metallic tin) | 20 | 20 | 20 | 20 | 20 | 20 | 20 | 20 |
| Sulfuric acid (mL/L) | 100 | 100 | 100 | 100 | 100 | 100 | 100 | 100 |
| Surfactant A g/L | 2.25 | 2.25 | 2.25 | 2.25 | 2.25 | 2.25 | 2.25 | 2.25 |
| Surfactant B g/L | 0.5 | | - | - | - | | | |
| Surfactant C g/L | | 0.5 | | | | | | |
| Surfactant D g/L | | | 0.5 | | | | | |
| Surfactant E g/L | | | | 0.5 | | | | |
| Surfactant F g/L | | | | | 0.5 | | | |
| Surfactant G g/L | | | | | | 0.5 | | |
| Surfactant H g/L | | | | | | | 0.5 | |
| Surfactant I g/L | | | | | | | | 0.5 |
| 1,10-phenanthroline ppm | 2 | 2 | 2 | 2 | 2 | 2 | 2 | 2 |
| Slit hull cell test results | good | good | good | good | Burn deposit | Burn deposit | good | Burn deposit |
| Hull cell test #9 film thickness µm | 1.68 | 0.87 | 1.17 | 0.93 | 1.40 | 1.31 | 1.38 | 1.49 |
| Slit hull cell test #9 film thickness µm | 0.13 | 0.01 | 0.00 | 0.15 | 0.00 | 0.00 | 0.08 | 0.00 |

Surfactant A: Alkyl alcohol ethylene oxide, RO(CH₂CH₂O)xH, R=C₁₀H₂₁, X=8
Surfactant B: Imidazoline dicarboxylate having the following structure (trade name: AMPHOTERGE™ K-2, product of Lonza Inc.)
Surfactant C: Amine alkylene oxide adduct (non-ionic surfactant, trade name, ETHOMEEN™ C25, product of Lion Axo Co.), R is alkyl substituent - coconut alkyl, ethylene oxide added molar number x + y is 15, 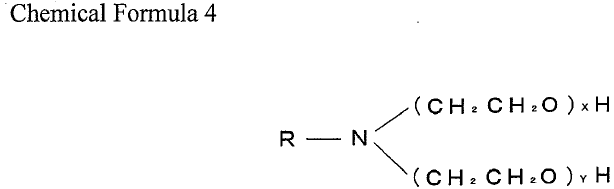 Surfactant D: Amine alkylene oxide adduct (non-ionic surfactant, trade name: ETHOMEEN™ T25, product of Lion Axo Co.), R is alkyl substituent - tallow alkyl, ethylene oxide added molar number x + y is 15
Surfactant E: Amine alkylene oxide adduct (non-ionic surfactant, trade name: ETHOPROPOMEEN™ C 18/18, product of Lion Axo Co.), R is alkyl substituent - coconut alkyl, ethylene oxide X propylene oxide added molar number x + y + w + z is 16 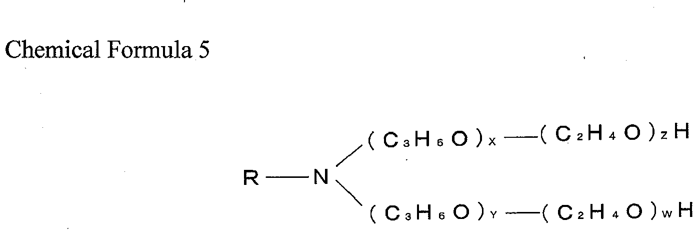 Surfactant F: Diamine alkylene oxide adduct (non-ionic surfactant, trade name: ETHODUOMEEN™ T25, product of Lion Axo Co.), R is alkyl substituent - tallow alkyl, ethylene oxide added molar number x + y + z is 15 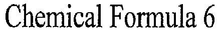 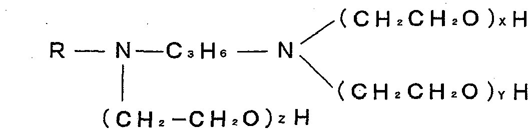 Surfactant G: N-methyl-N-oleyl taurine sodium salt a sulfonic acid-type non-ionic surfactant. 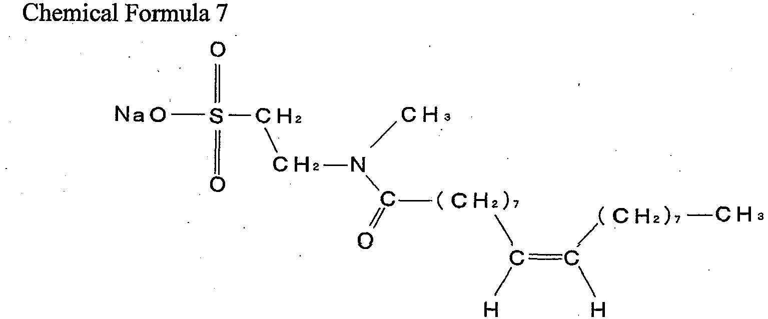 Surfactant H: Imidazoline monocarboxylate (trade name: NISSAN ANON™ GLM-R, product of Nichiyu Inc.) 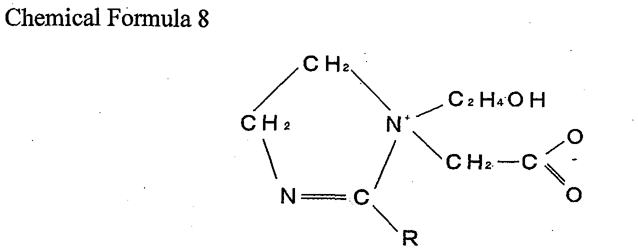 Surfactant I: 1-methyl-1-hydroxyethyl-2-tallow alkyl imidazolinium chloride (cationic surfactant, trade name: NISSAN CATION™ AR-4, product of Nichiyu Inc.)

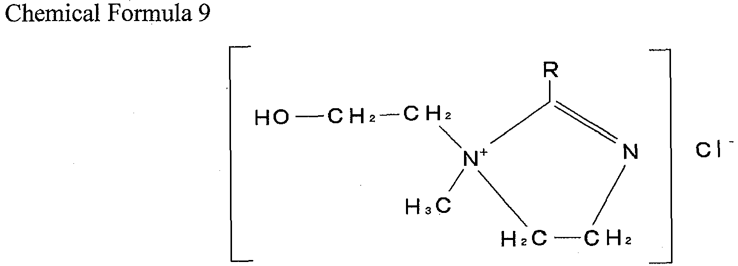

The results are shown in Table 3. Examples using surfactants C to I instead of surfactant B, Comparative Examples 11 to 17, all produced thin plating films or did not form plating films at all. The surfactant used in Comparative Example 16, Imidazoline monocarboxylate produced lower results than the imidazoline dicarboxylate of this application. Furthermore, the surfactant used in Comparative Example 17, cationic surfactant with an imidazole ring, did not result in any plating at all, in contrast to the present invention.

## Claims

1. A tin plating solution comprising a tin ion source, at least one non-ionic surfactant, imidazoline dicarboxylate and 1,10-phenanthroline, wherein said non-ionic surfactant is an alkyl alcohol ethylene oxide adduct containing 7 or more moles of ethylene oxide substituents in a molecule.

2. The tin plating solution according to Claim 1, further comprising an antioxidant.

3. The tin plating solution of Claim 1 or Claim 2, wherein said non-ionic surfactant contains 7 to 20 moles of ethylene oxide substituents in the molecule.

4. The tin plating solution of any of Claims 1 to 3, wherein the concentration of said non-ionic surfactant is in the range of 1 to 4.5 g/L.

5. The tin plating solution of any of Claims 1 to 4, wherein the concentration of said imidazoline dicarboxylate is in the range of 0.2 to 1.0 g/L.

6. A method for plating on a printed board having through-holes and fine patterns, wherein the tin plating solution of any of Claims 1 to 5 is used to form a metal resist.

## Patentansprüche

1. Eine Zinnplattierungslösung, beinhaltend eine Zinnionenquelle, mindestens ein nichtionisches Tensid, Imidazolindicarboxylat und 1,10-Phenanthrolin, wobei das nichtionische Tensid ein Alkylalkohol-Ethylenoxid-Addukt ist, das 7 oder mehr Mole Ethylenoxidsubstituenten in einem Molekül enthält.

2. Zinnplattierungslösung gemäß Anspruch 1, ferner beinhaltend ein Antioxidationsmittel.

3. Zinnplattierungslösung gemäß Anspruch 1 oder Anspruch 2, wobei das nichtionische Tensid 7 bis 20 Mole Ethylenoxidsubstituenten in dem Molekül enthält.

4. Zinnplattierungslösung gemäß einem der Ansprüche 1 bis 3, wobei die Konzentration des nichtionischen Tensids in dem Bereich von 1 bis 4,5 g/l liegt.

5. Zinnplattierungslösung gemäß einem der Ansprüche 1 bis 4, wobei die Konzentration des Imidazolindicarboxylats in dem Bereich von 0,2 bis 1,0 g/l liegt.

6. Ein Verfahren zum Plattieren auf einer Leiterplatte mit Durchgangslöchern und feinen Strukturen, wobei die Zinnplattierungslösung gemäß einem der Ansprüche 1 bis 5 verwendet wird, um ein Metallresist zu bilden.

## Revendications

1. Une solution de placage d'étain comprenant une source d'ions étain, au moins un tensioactif non ionique, du dicarboxylate d'imidazoline et de la 1,10-phénanthroline, dans laquelle ledit tensioactif non ionique est un adduit d'oxyde d'éthylène alcool alkylique contenant 7 moles ou plus de substituants d'oxyde d'éthylène dans une molécule.

2. La solution de placage d'étain selon la revendication 1, comprenant en outre un antioxydant.

3. La solution de placage d'étain de la revendication 1 ou de la revendication 2, dans laquelle ledit tensioactif non ionique contient de 7 à 20 moles de substituants d'oxyde d'éthylène dans la molécule.

4. La solution de placage d'étain de n'importe lesquelles des revendications 1 à 3, dans laquelle la concentration dudit tensioactif non ionique se situe dans la gamme allant de 1 à 4,5 g/L.

5. La solution de placage d'étain de n'importe lesquelles des revendications 1 à 4, dans laquelle la concentration dudit dicarboxylate d'imidazoline se situe dans la gamme allant de 0,2 à 1,0 g/L.

6. Un procédé pour le placage sur une carte imprimée pourvue de trous débouchants et de fines impressions, dans lequel la solution de placage d'étain de n'importe lesquelles des revendications 1 à 5 est utilisée pour former une réserve métallique.
